Europäisches Patentamt

European Patent Office

Office européen des brevets

(11) Veröffentlichungsnummer: **0 002 433**
**B1**

(12) **EUROPÄISCHE PATENTSCHRIFT**

(45) Veröffentlichungstag der Patentschrift:
12.08.81

(51) Int. Cl.³: **H 01 L 31/18, H 01 L 31/02**

(21) Anmeldenummer: 78100845.3

(22) Anmeldetag: 07.09.78

(54) **Verfahren zum Herstellen von Silicium-Photoelementen.**

(30) Priorität: 08.12.77 DE 2754652

(43) Veröffentlichungstag der Anmeldung:
27.06.79 Patentblatt 79/13

(45) Bekanntmachung des Hinweises auf die Patenterteilung:
12.08.81 Patentblatt 81/32

(84) Benannte Vertragsstaaten:
BE DE FR GB

(56) Entgegenhaltungen
**DE-B-1 014 673**
**FR-A-1 339 543**
**US-A-3 555 669**
**US-A-3 956 023**
**US-A-4 011 582**
**US-A-4 056 879**
**IEEE TRANSACTIONS ON ELECTRON DEVICES,**
**vol. ED-23, no. 10, Oktober 1976**
**New York**
**D. J. CONNOLLY, Seiten 1195—1197**

(73) Patentinhaber: **International Business Machines Corporation, Armonk, N.Y. 10504 (US)**

(72) Erfinder: **Alameddine, Oussama, Dipl.-Ing., Seestrasse 27, D-7036 Schönaich (DE)**
Erfinder: **Briska, Marian, Dipl.-Ing., Nürtinger Strasse 51, D-7030 Böblingen (DE)**
Erfinder: **Thiel, Klaus Peter, Reiherweg 2, D-7030 Böblingen (DE)**

(74) Vertreter: **Busch, Robert, Dipl.-Ing., Schönaicher Strásse 220, D-7030 Böblingen (DE)**

## Verfahren zum Herstellen von Silicium-Photoelementen

Die Erfindung betrifft ein Verfahren, wie es dem Oberbegriff des Patentanspruchs 1 zu entnehmen ist.

Zur Herstellung von Silicium-Photoelementen, insbesondere Sonnenzellen, sind bisher eine große Anzahl von Verfahrensschritten erforderlich, so daß allein schon hieraus ein erheblicher Herstellungsaufwand unabläßlich erscheint. Hierbei muß zunächst ein geeigneter Si-Wafer einer Diffusion zur Bildung eines PN-Überganges unterworfen werden, anschließend eine antireflektierende Schicht entweder durch Oberflächenzerstörung oder Aufdampfen besonderer Schichten bereitgestellt werden, um anschließend die Elektrodenmetallisierung anzubringen, wovon dann die eine abschließend in üblicher Weise als Kammelektrode ausgebildet wird. Das Absorptionsvermögen und damit der Wirkungsgrad derartig hergestellter Sonnenzellen läßt sich erheblich verbessern, wenn, wie bereits in der deutschen Offenlegungsschrift 1 621 511 beschrieben, die bestrahlte Oberfläche mit einem dichten Netzwerk von Si-Pyramiden überzogen wird. Dies läßt sich durchführen, indem eine Silicium-Monokristall-Oberfläche in (100)-Richtung angeätzt wird, so daß dann nach diesem Ätzvorgang Silicium-Pyramiden mit ihren (111)-Flanken auf der Oberfläche verbleiben. Nachteilig hierbei ist es, daß der PN-Übergang nachher hergestellt werden muß und daß das Ausgangsmaterial, nämlich die Silicium-Monokristallschicht, relativ teuer ist. Wenn auch als Ersatz nicht-monokristallines Silicium, jedoch überhaupt nicht polykristallines Silicium, Anwendung finden kann, so ist dann noch von der Tatsache nicht abzusehen, daß die Herstellung eines derartigen Grundmaterials immerhin noch einen gewissen Aufwand erfordert und damit nicht ganz einfach ist.

Andererseits ist zwar die Verwendung von polykristallinem und amorphen Silicium für Sonnenzellen an sich bekannt, jedoch ergeben sich für das Anbringen der Elektroden und des Aufbringens von Antireflexbelägen, insbesondere aber für das Erzeugen eines flachen PN-Übergangs, nicht unwesentliche Schwierigkeiten. Eine Zusammenfassung über Sonnenzellen üblicher Bauart findet sich in der Zeitschrift »Umschau« Band 77 (1977), Heft 13, unter dem Titel »Elektrische Energie von der Sonne«, Seiten 421 bis 427.

Demgegenüber liegt der Erfindung die Aufgabe zugrunde, ein Herstellungsverfahren für Sonnenzellen bereitzustellen, das gegenüber bisher wesentlich vereinfacht ist und bei sehr viel geringerem Aufwand betriebszuverlässige und äußerst wirksame Sonnenzellen bzw. Photoelemente in einfachster Weise bereitzustellen vermag.

Erfindungsgemäß wird diese Aufgabe gelöst, wie es dem Kennzeichen des Patentanspruchs 1 zu entnehmen ist. Im Vergleich zu bisher wird also beim Auftragen des Antireflexbelages in einem Halbleiter ohne PN-Übergang ausgegangen, da gemäß der Erfindung gleichzeitig mit der Bildung des Antireflexbelages in vorteilhafter Weise auch der PN-Übergang eingebaut wird, indem aus der auf den N-Halbleiter niedergeschlagenen Beschichtung unter Einfluß der Aufheiztemperatur ein dichtes Netzwerk von Pyramiden, bestehend aus aluminiumdotiertem, also P-leitendem Silicium, aufgebracht wird. Hieraus allein ergibt sich bereits ein wesentlicher Vorteil, nämlich der, daß kein besonderer Diffusionsverfahrensschritt zur Bildung des PN-Übergangs erforderlich ist, so daß die sonst erforderlichen, umständlichen und aufwendigen Maßnahmen derartiger Diffusionsverfahrensschritte, wie das Abdecken der jeweiligen Waferrückseite, um die Bildung eines zweiten PN-Übergangs zu verhindern oder die Anwendung hoher Temperaturen > 800 C. vollständig entfallen können. Außerdem ist kein besonderer Verfahrensschritt zum Vorsehen einer Gegenelektrode erforderlich, da diese bereits gleichzeitig mit Bildung der Silicium-Pyramiden als Antireflexbelag auf der Halbleiteroberfläche in vorteilhafter Weise gebildet wird, da ja nach Abscheiden des Siliciums ein Aluminium-Überzug verbleibt, der die Pyramiden abdeckt. Mit Hilfe relativ einfacher Verfahren läßt sich anschließend aus diesem Al-Überzug die kammartige Gegenelektrode herausarbeiten.

Da die Halbleiteroberfläche nach Anwenden des erfindungsgemäßen Verfahrens mit mikroskopisch kleinen Pyramiden übersät ist, ergibt sich daraus ein äußerst wirksames Antireflexionsvermögen und dementsprechende Lichtabsorption. Die mit dem Pyramiden-Netzwerk überzogene Halbleiteroberfläche bewirkt außerdem durch interne Mehrfachreflexionen des langwelligen Lichtes zwischen der Rück- und Vorderseite des photoelektrischen Elementes eine entsprechende Erhöhung des Wirkungsgrades.

Wenn es auch für das Erreichen eines hohen Wirkungsgrades der Sonnenzelle von besonderem Vorteil ist, von einer niedrig dotierten Si-Lage auszugehen, läßt sich andererseits auch eine Dotierung oberhalb von $5 \times 10^{18}$ Fremdatomen pro $cm^3$ anwenden, wobei die Kontaktierung der N-dotierten Lage besonders einfach wird. Bei Verwendung von nicht-monokristallinem Silicium kann erst eine $N^+$-Schicht, die dann in eine $N^-$-Schicht übergeht, erzeugt werden. Eine typische $N^+$-Konzentration wäre dann $10^{20}$ Fremdatome/$cm^3$, wohingegen eine typische $N^-$-Konzentration $5 \times 10^{15}$ Fremdatome/$cm^3$ aufweisen könnte.

Zur Durchführung der erfindungsgemäßen Verfahrensschritte ergeben sich verschiedene Möglichkeiten, nämlich einmal mit Hilfe der Kathodenzerstäubung aus einer siliciumreichen Aluminiumlegierung als Target die Si-Lage

entsprechend zu beschichten oder Aluminium oder Silicium auf die Si-Lage mittels Vakuumbedampfung aufzutragen. Bei beiden Verfahrensschritte dient in vorteilhafter Weise eine Legierung als Ausgangsmaterial, bei der 1 bis 5 Gewichtsprozent von in Aluminium gelöstem Silicium unter Berücksichtigung der maximalen Siliciumlöslichkeit bei der verwendeten Aufheiztemperatur gewählt wird. Bei Verwendung getrennter Tiegel für Aluminium und Silicium müssen bei gleichzeitiger Beheizung entsprechend unterschiedliche Aufdampfraten für Aluminium und Silicium angewendet werden.

Andererseits ist es auch möglich, die Erfindung durchzuführen, indem getrennte Schichten von Aluminium und Silicium auf die Si-Lage aufgebracht werden. In vorteilhafter Weise ist dabei die zunächst aufgetragene Aluminiumschicht etwa 400 nm dick und die hierauf niedergeschlagene Siliciumschicht sollte eine Dicke von 200 nm aufweisen.

Bei Verwendung einer monokristallinen Si-Lage werden vorteilhafter Weise Aufheiztemperatur und Aufheizdauer so gewählt, daß sich ein möglichst tiefer PN-Übergang einstellt, und zwar bis auf 0,1 μm, gemessen von der Oberfläche. Bei Verwendung von korngrenzfreien, monokristallinen Si-Lagen ist es weiterhin von Vorteil, eine Aufheiztemperatur von mehr als 500°C bei einer Aufheizdauer von 4 bis 5 Stunden Dauer anzuwenden.

Dank der Vorteile des erfindungsgemäßen Verfahrens ist es auch ohne weiteres möglich, nicht-monokristallines Silicium als Si-Lage zu verwenden. Selbstverständlich gilt entsprechendes auch für eine Si-Lage, die mit Korngrenzen durchzogen ist. In vorteilhafter Ausgestaltung der Erfindung wird hierbei z. B. amorphes Silicium auf eine Substratoberfläche, bestehend insbesondere aus Stahl, niedergeschlagen, so daß sich eine einige 10 μm dicke, amorphe, N-dotierte Si-Lage auf dieser Metallsubstratoberfläche bildet. Hierauf erfolgt dann, wie bereits erwähnt, das Auftragen von Aluminium und Silicium.

Zur Bildung der amorphen Si-Lage lassen sich verschiedene Verfahren anwenden, die an sich bekannt sind, nämlich einmal Kathodenzerstäubung und zum anderen Reaktionsniederschlag, wie in der »Frankfurter Zeitung« vom 28. 09. 1977 unter dem Titel »Amorphes Silicium für die Halbleiterfertigung« angegeben; wo von einer gasförmigen Siliciumverbindung, nämlich Silan, ausgegangen wird, das in einer elektrischen Entladung disoziiert wird, so daß sich auf einem geheizten Substrat ein amorpher Siliciumfilm ausbilden kann.

Allgemein wird die Temperung zur Bildung des Pyramidennetzwerks gemäß der Erfindung in neutraler Atmosphäre durchgeführt, wie z. B. Argon, um Reaktionen auszuschließen.

Die Ausbildung der kammartigen Gegenelektrode aus der nach der Temperung verbleibenden Al-Beschichtung kann mit Hilfe an sich bekannter photolithographischer und drucktechnischer Verfahren erfolgen oder aber auch in vorteilhafter Weise durch Auftragen einer Wachsschicht auf den freigesetzten Al-Dünnfilm nach Temperung. Die Wachsschicht kann aus Vakuumkitt bestehen und wird in Form der gewünschten Kammelektrode aufgebracht. Die nach Aufbringen dieser Wachsschicht freibleibenden Metalloberflächenbereiche werden einer Lösung, bestehend aus $H_3PO_4HNO_3$, HCl und $H_2O$ im Volumenverhältnis 20 : 10 : 10 : 60 ausgesetzt, so daß das Metall hierunter abgeätzt wird. Das verbliebene Wachs wird dann anschließend mittels $CHCl_3$ abgelöst.

Wie ersichtlich, wird also, dank der Erfindung, ein relativ einfaches Herstellungsverfahren für photoelektrische Elemente, bestehend aus Silicium, bereitgestellt, welches in seinen Verfahrensschritten eines wesentlich geringeren Aufwandes bedarf als es bei bisher üblichen Verfahren der Fall ist. Dadurch, daß die gewählte Aufheiztemperatur relativ gering ist, ergibt sich keine Diffusion von A1 in die Si-Lage entlang der Korngrenzen, so daß hierfür ohne weiteres amorphes, polykristallines und auch quasi-monokristallines Silicium Verwendung finden kann.

Die Erfindung wird anschließend anhand einer Ausführungsbeispielsbeschreibung mit Hilfe der unten aufgeführten Zeichnungen näher erläutert. Es zeigt

Fig. 1A—1G Querschnittsausschnitte des sich bei den einzelnen Verfahrensschritten jeweils ergebenden Zwischenproduktes in der Herstellung des Silicium-Photoelements gemäß der Erfindung,

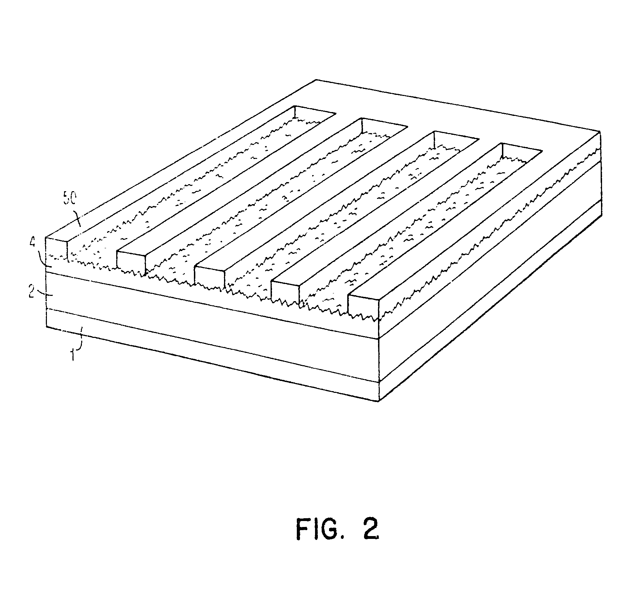

Fig 2 eine perspektivische, schematische Ansicht des erfindungsgemäß fertiggestellten Silicium-Photoelements.

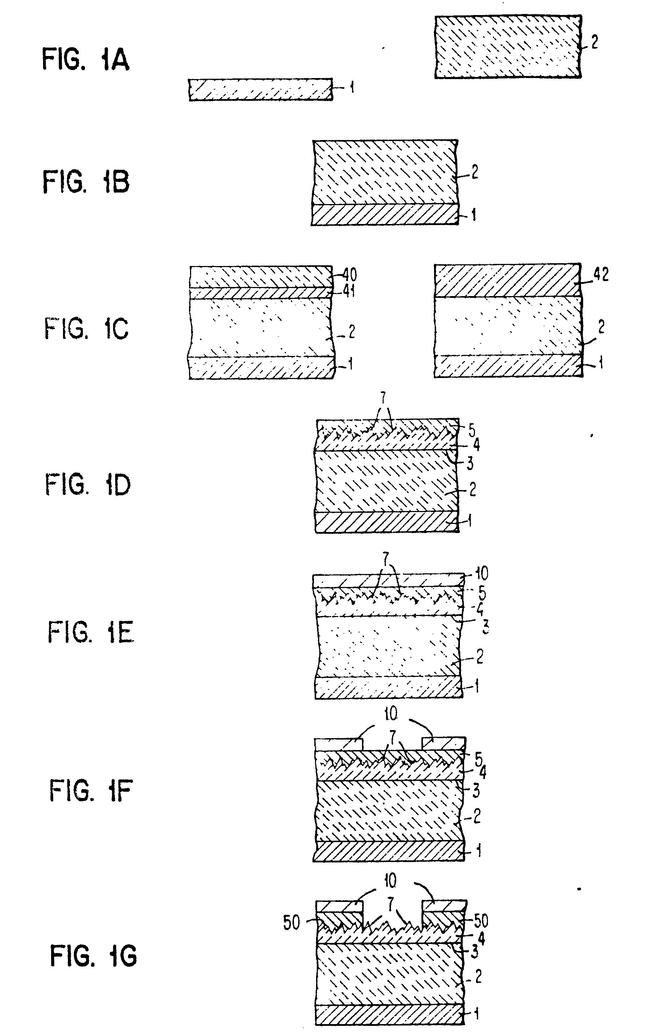

Die in Fig. 1 dargestellten Querschnittsausschnitte der sich bei den Verfahrensschritten A bis G ergebenden Zwischenprodukte stellen keine maßstäblich genauen Abbildungen dar, so daß also keine proportionale Vergrößerung der einzelnen Elemente vorliegt. Gleiche Elemente der einzelnen Querschnittsausschnitte besitzen jedoch jeweils gleiches Bezugszeichen. Das erfindungsgemäße Verfahren geht dabei von einer Si-Lage 2 aus, die entweder durch einen Silicium-Wafer allein, wie rechts beim Verfahrensschritt A gezeigt, oder wie beim Verfahrensschritt A, links durch eine auf einem, zweckmäßigerweise gleichzeitig als eine der Elektroden dienendem Substrat 1 niedergeschlagenen Schicht 2 dargestellt werden kann, wie es sich aus Verfahrensschritt B ergibt. Die Si-Lage 2 wird durch einen N-Halbleiter gebildet, der normal dotiert ist, d. h. unterhalb von $5 \times 10^{18}$ Fremdatomen/$cm^3$, wobei dann allerdings vor Metallisierung die Si-Lage 2 nach den bekannten Methoden zur Herstellung ohmscher Kontakte mit $N^-$-dotiertem Si Anwendung findet. So ist z. B. in »Journal of the Electrochemical Society«. Band 104, Nr. 4, April 1957 unter dem Titel »Electroless Nickel Plating for Making Ohmic Contacts to Silicon« auf den Seiten 226 bis 230 ein Verfahren beschrieben, bei dem Nickel aus einer alkalischen Lösung stromlos auf ein Si-Substrat mit $5 \times 10^{15}$ Phosphoratomen/cm³ ausgeschieden wird, um dann eine Temperung bei 700°C durchzuführen. Hierbei ergibt sich beispielsweise ein Kontakt-Quadratflächenwiderstand von ca. 0,01 Ω.

In einer weiteren Veröffentlichung in der gleichen Zeitschrift, Band 103, Nr. 4, April 1956 unter dem Titel »Five Metal Hydrides as Alloying Agents on Silicon«, auf den Seiten 218 bis 220 zeigt sich eine Methode zum Kontaktieren von $N^-$-dotiertem Silicium durch Beschleunigung des Legierungsvorgangs von Blei-Zinnlot mit Hilfe von Zirkon- und Titanhydriden. Typische Kontaktwiderstände von 0,001 $\Omega$/cm² lassen sich hierbei erreichen.

Ebenfalls unter Anwenden von Blei-Zinnlot und Verschmelzen mittels Laserstrahlen lassen sich ohmsche Kontakte auf Si-Halbleitern aufbringen, wie es in der Zeitschrift »Soviet Physics Semiconductors«, Band 3, Nr. 11, Mai 1970, Seiten 1383 bis 1385 beschrieben ist.

Schließlich ist im Buch von Lindmayer-Wrigley »Fundamental of Semiconductor Devices«, auf den Seiten 358 und 359 die Bildung ohmscher Kontakte durch Hervorrufen hoher Defektdichten mittels mechanischem Aufrauhens der Kristalloberfläche, z. B. Sandblasen, angegeben. In allen Fällen ergibt sich, daß die Ausbildung einer Schottky-Sperrschicht verhindert wird, die andererseits bei Betrieb des erfindungsgemäß hergestellten Silicium-Photoelements den Wirkungsgrad nicht unwesentlich beeinträchtigen würde.

Die Si-Lage 2 selbst kann aus den verschiedensten Si-Modifikationen bestehen. Bei quasimonokristalliner und bei polykristalliner Struktur, wie es sich aus der US-Patentschrift 40 19 195 und aus der deutschen Offenlegungsschrift 23 63 135 ergibt, liegt ein äußerst günstiges Ausgangsmaterial für die Herstellung von Silicium-Sonnenzellen vor, die bei Herstellung unter Anwendung des erfindungsgemäßen Verfahrens gegenüber bisher um Größenordnungen billiger sind.

Mit Si-Pyramiden übersäte Halbleiteroberflächen als solche lassen sich durch epitaxiales Wachstum von 150—300 µm dichten Schichten, wie im Buch »Metallurgial Society Conferences«, Bd. 12, unter dem Titel »Metallurgy of Elemental and Compounds Semiconductors« auf den Seiten 246, 247, erschienen bei »Intercience Publishers«, New York/London 1961, angegeben, herstellen. Derartige Strukturen lassen sich aber nicht als Solarzellen anwenden, da die Ausbildung eines PN-Übergangs in definierter Tiefe nicht in einem und demselben Verfahrensgang bereitgestellt werden kann.

Auch amorphes Silicium läßt sich gemäß der Erfindung zur Ausbildung der Si-Lage 2 auftragen. Dies kann in an sich bekannter Weise mittels Aufdampfen oder Kathodenzerstäuben in gebräuchlichen Apparaturen erfolgen. Voraussetzung ist allerdings, daß bei diesem Vorgang ein entsprechender Anteil an N-Fremdatomen beteiligt ist, deren Konzentration in vorteilhafter Weise von $N^+$- zur $N^-$-Dotierung in Richtung zur pyramidenbesetzten Oberfläche abnimmt, damit sich die gewünschte Dotierung der Si-Lage 2 einstellen kann. Eines der möglichen Auftragungsverfahren ist auch dem obengenannten Artikel »Amorphes Silicium für die Halbleiterfertigung« in der »Frankfurter Zeitung« vom 28. 09. 1977 zu entnehmen. Es bleibt jedoch festzuhalten, daß bei allen anwendbaren Verfahren zum Niederschlag einer amorphen Si-Lage 2 die in vorgegebener Weise mit N-Fremdatomen dotiert ist, keinerlei Schwierigkeiten bei der Fertigstellung des Silicium-Photoelements auftreten, da bei Anwendung des erfindungsgemäßen Verfahrens nach Aufbringen der Si-Lage 2 auf das jeweilige Substrat 1 bzw. nach entsprechender Behandlung des Wafers hierin kein PN-Übergang mehr eingebracht zu werden braucht. Jedenfalls kann ein Metallsubstrat 1 der Si-Lage 2 gleichzeitig als negative Elektrode des herzustellenden Silicium-Photoelements dienen.

Bei Verwendung einer amorphen Silicium-Modifikation läßt sich z. B. wie folgt verfahren:

Gemäß A in der linken Seite der Fig. 1 dient als Elektrode, also für das Substrat 1 der Si-Lage 2, z. B. ein Stahlplättchen. Dieses Stahlsubstrat 1 wird in eine bekannte Kathodenzerstäubungseinrichtung eingegeben, um hierauf N-leitendes Silicium im amorphen Zustand als Lage 2 in einer Dicke von einigen 10 µm aufzustäuben. Der sich ergebende N-leitende Niederschlag als Si-Lage 2 ist in hervorragender Weise für das Aufbringen des Antireflexbelages gemäß der Erfindung in Form des Netzwerks der Si-Pyramiden 7 unter gleichzeitiger Bildung der P-Zone 4 und der Gegenelektrode 5 geeignet.

Nach Abschluß des Verfahrensschrittes B liegt also ein mit einer Metallelektrode 1 versehener Halbleiter 2 vor. Auf diesen monokristallinen, quasi-monokristallinen, polykristallinen oder amorphen Halbleiter der Si-Lage 2 wird anschließend die Aluminium-Siliciumbeschichtung gemäß dem Verfahrensschritt C aufgebracht. Diese Beschichtung läßt sich entweder als Legierungsschicht 42 oder in Form jeweils getrennter Aluminium- und Siliciumfilme 40, 41 auf die Si-Lage 2 niederschlagen, die, wie gesagt, entweder ein Wafer oder eine auf einem Substrat aufgebrachte Schicht darstellen kann. In anderen Fällen jedoch ist es möglich, hierzu entweder Kathodenzerstäubungs- oder Aufdampfverfahren anzuwenden, wie sie in der einschlägigen Technik durchaus bekannt sind. Bei beiden Niederschlagsverfahren läßt sich in vorteilhafter Weise als Ausgangsmaterial eine siliciumreiche Aluminiumlegierung anwenden. Je nach Höhe der Aufheiztemperatur, wie sie nach Aufbringen der siliciumreichen Aluminiumlegierung auf die Si-Lage 2 Anwendung findet, beträgt der Anteil des Siliciums im Aluminium 1 bis 5 Gewichtsprozent, da nämlich die Löslichkeit von Silicium in Aluminium mit steigender Aufheiztemperatur wächst.

Wird ein Verdampfungsvorgang zum Be

schichtungsniederschlag angewendet, dann geschieht dies zweckmäßiger Weise im Vakuum, um das Eindringen von Verunreinigungen in den Beschichtungsniederschlag 42 von vornherein auszuschalten. Der Tiegel mit der hierin enthaltenen siliciumreichen Aluminiumlegierung wird also entsprechend beheizt, bis sich die Beschichtung 42 auf der Si-Lage 2 in ausreichender Dicke eingestellt hat.

Eine andere Möglichkeit zum Aufdampfen des Beschichtungsniederschlags 42 auf die Si-Lage 2 läßt sich so durchführen, daß je für Aluminium und Silicium ein besonderer Tiegel verwendet wird, wobei dann bei gleichzeitiger Beheizung jeweils unterschiedliche Aufheizungsraten entsprechend der Löslichkeit von Silicium in Aluminium berücksichtigt werden müssen. Schließlich lassen sich auch, wie beim Verfahrensschritt C auf der linken Seite gezeigt, getrennte Aluminium- und Siliciumschichten 41, 40 auf die Si-Lage 2 aufbringen, und zwar ebenfalls unter Anwenden der beiden obengenannten Verfahren, wobei dann natürlich jeweils nur ein Tiegel beim Niederschlagen einer Schicht wirksam ist. Hierbei wird in vorteilhafter Weise zunächst eine 400 nm dicke Aluminiumschicht 41 auf die Si-Lage 2 aufgebracht, um anschließend die 200 nm dicke Siliciumschicht 40 auf die Aluminiumschicht 41 ihrerseits niederzuschlagen. Hervorzuheben ist an dieser Stelle, daß Aluminium in einem Siliciumhalbleiter P-Fremdatome bereitzustellen vermag.

Nach Aufbringen der Silicium-Aluminium-Beschichtung 42 bzw. 40, 41 schließt sich erfindungsgemäß der Temperungsvorgang an, der in allen Fällen unterhalb des Schmelzpunktes des eutektischen Gemisches von Aluminium/Silicium (89 : 11 Gewichtsprozent) erfolgt. Bei diesem Temperungsvorgang (Verfahrensschritt D) setzen sich Si-Pyramiden 7 im Niederschlag 4 auf die Si-Lage 2 als dichtes Netzwerk ab, so daß nach Abschluß des Verfahrensschrittes D die Halbleiteroberfläche mit Si-Pyramiden 7 dicht übersät ist. Im Falle einer monokristallinen oder quasi-monokristallinen Si-Lage 2 ergeben sich epitaxial aufgetragene, P-dotierte Si-Pyramiden 7. Bedeutsam ist, daß bei diesem Vorgang zwar die Si-Pyramiden 7 mit P-Fremdatomen dotiert werden, jedoch die darunterliegende Si-Lage 2 im wesentlichen keine Al-Atome aufzunehmen vermag, da die hierzu erforderliche Diffusionstemperatur in Verbindung mit der ebenfalls notwendigen Diffusionsdauer bei Anwendung des erfindungsgemäßen Verfahrens nicht erreicht wird. Der Temperungsvorgang gemäß Verfahrensschritt D wird also unterhalb der eutektischen Temperaturen Al—Si durchgeführt und findet in neutraler Atmosphäre, vorzugsweise jedoch in Argon, statt, um unerwünschte Reaktionen auszuschließen.

Die zur Temperung angewendete Aufheiztemperatur ist entscheidend für die Höhe der sich ausbildenden Si-Pyramiden 7 und für die Tiefe des PN-Übergangs 3. So zeigt sich, daß bei relativ hoher Aufheiztemperatur die Kristallisationsgeschwindigkeit entsprechend höher ist, so daß sich niedrigere Si-Pyramiden 7 aufgrund der Ausbildung relativ kleiner Kristalle ergeben, und dabei auch der PN-Übergang 3 in größere Tiefe zu liegen kommt. Zu berücksichtigen ist allerdings, daß außerdem auch die Temperungsdauer von gewissem Einfluß sein kann. Bei relativ niedriger Temperatur bilden sich dementsprechend größere Si-Pyramiden 7 aus, wobei dann jedoch der PN-Übergang auch flacher zu liegen kommt; aber, wie bereits erwähnt, durch entsprechend längere Temperungsdauer tiefer gelegt werden kann. So kann z. B. bei einer Temperungsdauer von 4 bis 5 Stunden die Aufheiztemperatur bei 500°C liegen, wie im angeführten Ausführungsbeispiel mit einer 400 nm dicken Aluminium-Schicht 41 auf der Si-Lage 2 und mit einer auf diese Aluminium-Schicht 41 in einer Dicke von 200 nm aufgetragenen Si-Schicht 40.

Im Ausgangsmaterial für die Beschichtung der Si-Lage 2 sollte der Aluminiumanteil so groß gewählt sein, daß die sich nach Anwendung des Temperungsvorganges im Verfahrensschritt D ergebende Dicke der Aluminiumschicht 5 derart einstellt, daß der elektrische Widerstand in dieser Aluminiumschicht 5 für die Anwendung als Silicium-Photoelement ausreichend niedrig ist. Hierbei muß natürlich berücksichtigt werden, daß diese Aluminiumschicht 5 ja noch zur Bildung einer kammartigen Elektrode 50 unter Anwenden der Verfahrensschritte E bis G ausgeätzt werden muß. Da neben dem Widerstand in der P-Zone 4 der Elektrodenwiderstand für den Wirkungsgrad eines Silicium-Photoelements von erheblicher Bedeutung ist, muß diesem Punkt entsprechend auch hinreichende Beachtung geschenkt werden.

Zusammenfassend läßt sich sagen, daß die Aufheiztemperatur bei Temperung im Verfahrensschritt D für die Höhe der sich auf der Si-Lage 2 bildenden Si-Pyramiden 7 und für die Tiefe des PN-Übergangs 3 ganz entscheidend ist. Mit bei Temperung steigender Temperatur wächst auch die Kristallisationsgeschwindigkeit, so daß sich niedrigere Si-Pyramiden 7 auf der Oberfläche der Si-Lage 2 ausbilden, da hierbei kleinere Kristalle entstehen. Außerdem wächst die Tiefe des PN-Übergangs 3 mit der Aufheiztemperatur an, wobei natürlich auch die Dauer des Temperungsvorganges eine Rolle spielt, da bei längerer Aufheizdauer der PN-Übergang 3 entsprechend tiefer zu liegen kommt. Ist die Aufheiztemperatur bei Temperung nicht so hoch, dann bilden sich entsprechend größere Kristalle an der Oberfläche Si-Lage 2 aus, wobei sich gleichzeitig der PN-Übergang 3 entsprechend flacher einstellt. Jedoch kann, wie gesagt, durch entsprechendes Erhöhen der Aufheizdauer dieser PN-Übergang 3 tiefer gelegt werden.

Bei Verwendung eines Monokristalls als Si-Lage 2 sollte der PN-Übergang so tief wie möglich liegen, nämlich bis etwa zu 0,1 µm, gemessen von der Oberfläche.

Das sich nach Abschluß des Verfahrensschrittes D ergebende Zwischenprodukt enthält demnach eine N-dotierte Si-Lage 2, die mit einer P-dotierte Si-Pyramiden 7 enthaltenden Schicht 4 an ihrer, der Elektrode 1 abgewandten Fläche in Form eines dichten Netzes überzogen ist, wobei die Si-Pyramiden 7 ihrerseits hinwiederum mit einer Aluminium-Metallisierung 5 bedeckt sind, die, wie erwähnt, in für die Anwendungszwecke erforderlicher Dicke aufgebracht ist und zur Darstellung der Gegenelektrode mittels der Verfahrensschritte E bis G herangezogen wird.

Die Si-Pyramiden 7 auf der Oberfläche der Si-Lage 2 ergeben sich in für das Antireflexionsvermögen ausreichender Dichte, wenn für den Verfahrensschritt C Silicium in entsprechender Menge vorgesehen wird. Obwohl die Si-Pyramiden 7 mikroskopisch klein sind, ist das Antireflexionsvermögen der Schicht 4 groß genug und damit hinreichend wirksam, da bei großer Dichte der Si-Pyramiden 7 auf der Oberfläche der Si-Lage 2 einfallende Lichtstrahlen bei Reflexion auf jeweils andere Si-Pyramiden 7 gelenkt werden und damit nicht wieder nach außen abgestrahlt werden können. Hinzu kommt, daß dank der mit den Si-Pyramiden 7 übersäten Oberfläche der Si-Lage 2 durch interne Mehrfachreflexionen des langwelligeren Lichtes zwischen Rück- und Vorderseite des Silicium-Photoelements eine zusätzliche Erhöhung des Wirkungsgrades herbeigeführt wird.

Zur speziellen Ausbildung der Gegenelektrode 50 in kammartiger Form lassen sich photolithographische Verfahren oder drucktechnische Verfahren bekannter Art anwenden, wie sie auch zur Herstellung von monolythisch integrierten Halbleiterschaltungen Anwendung finden. Eine speziell für das erfindungsgemäß herzustellende Silicium-Photoelement vorteilhafte Methode besteht darin, daß auf die Aluminiummetallisierung 5 gemäß Verfahrensschritt E eine Wachsschicht 10, z. B. Vakuumkitt, in Form der gewünschten Kammelektrode 50 aufgetragen wird (Verfahrensschritt F). Anschließend wird dann in Fortsetzung des Verfahrensschrittes F die freie Oberfläche der Aluminiummetallisierung 5 einer Ätzlösung ausgesetzt, die aus $H_3PO_4$, $HNO_3$, HCl und $H_2O$ im Volumen-Verhältnis 20 : 10 : 10 : 60 angesetzt ist, so daß sich die Aluminiummetallisierung 5 in gewünschter Weise abätzen läßt. Vorher abgedeckte Si-Pyramiden 7 werden bei Anwendung des Verfahrensschrittes G freigelegt und das sich noch auf der hierbei ergebenden Kammelektrode 50 befindende Wachs wird abschließend mittels einer $CHCl_3$-Lösung abgelöst. Die so gebildete Kammelektrode 50 bildet den Pluspol des erfindungsgemäß hergestellten Silicium-Photoelements, dessen Minuspol ja durch die bereits angebrachte Metallelektrode 1 dargestellt wird.

Abschließend läßt sich sagen, daß mit Hilfe des erfindungsgemäßen Verfahrens nur in zwei Verfahrensgängen der PN-Übergang 3, die Metallisierung der Gegenelektrode 50 und die Antireflexionsschicht 4 bei Herstellung eines Silicium-Photoelements gebildet werden. Dies allein stellt schon eine wesentliche Verringerung des Herstellungsaufwandes für Photoelemente dar. Wenn hinzukommt, daß dank der Anwendung des erfindungsgemäßen Verfahrens für die Si-Lage 2 nicht nur eine teure, monokristalline Struktur, sondern auch andere, wesentlich billigere Si-Modifikationen Anwendung finden können, dann liegt der Vorteil der Erfindung auf der Hand. Dieser Vorteil wird noch dadurch erhöht, daß der für die Bereitstellung eines Photoelements erforderliche PN-Übergang 3 nicht nachträglich erst in den Si-Halbleiter eingebracht zu werden braucht, sondern sich vielmehr selbsttätig bei Ausbildung der Si-Pyramiden 7 einstellt. Nicht zuletzt ergibt sich auch noch daraus eine wesentliche Vereinfachung des Herstellungsprozesses, daß gemäß der Erfindung die zur Herstellung erforderlichen Wärmeverfahrensschritte in abgeschlossenem Zyklus Anwendung finden können ohne daß die Werkstücke bzw. Zwischenprodukte kontaminierenden Einflüssen in den zwischen den einzelnen Verfahrensschritten gelegenen Phasen ausgesetzt sind.

**Patentansprüche**

1. Verfahren zum Herstellen von Silicium-Photoelementen, insbesondere Sonnenzellen, indem jeweils eine mit einer als Elektrode dienenden Metallschicht (1) bedeckte Si-Lage (2) auf der hierzu gegenüberliegenden Fläche mit einem dichten Netzwerk von Si-Pyramiden zur Bereitstellung eines Antireflexbelages überzogen wird, dadurch gekennzeichnet, daß nach Auftragen von Aluminium und Silicium (40, 41 bzw. 42) auf die für die Bereitstellung des Antireflexbelages (4) vorgesehene Oberfläche der jeweiligen N-dotierten Si-Lage (2) ein Aufheizvorgang bis unterhalb der eutektischen Temperatur von Aluminium-Silicium in neutraler Atmosphäre durchgeführt wird, bis sich Si-Pyramiden (7) ausbilden, die von einem Al-Dünnfilm (5) überzogen sind, der anschließend einem Abtragungsverfahrensschritt zur Ausbildung einer Elektrode (50) in Kammform ausgesetzt wird.

2. Verfahren nach Anspruch 1, dadurch gekennzeichnet, daß die Auftragung von Aluminium und Silicium (40, 41 bzw. 42) auf die Si-Lage (2) mittels Kathodenzerstäubung an einem Target, bestehend aus einer siliciumreichen Aluminiumlegierung, erfolgt.

3. Verfahren nach Anspruch 1, dadurch gekennzeichnet, daß die Auftragung von Aluminium und Silicium (40, 41 bzw. 42) auf die Si-Lage (2) mittels Vakuum-Bedampfung durchgeführt wird.

4. Verfahren nach Anspruch 2 oder 3, dadurch gekennzeichnet, daß als Ausgangsmaterial eine Legierung von 1 bis 5 Gewichtsprozent von Silicium in Aluminium unter Berücksichtigung maximaler Siliciumlöslichkeit bei der jeweils verwendeten Aufheiztemperatur gewählt wird.

5. Verfahren nach Anspruch 3 und 4, dadurch gekennzeichnet, daß bei Verwendung getrennter Tiegel für Aluminium und Silicium unter ihrer gleichzeitigen Beheizung entsprechend unterschiedliche Aufdampfraten für Aluminium und Silicium Anwendung finden.

6. Verfahren nach den Ansprüchen 1, 3 und 5, dadurch gekennzeichnet, daß zunächst eine 400 nm dicke Aluminiumschicht (41) und anschließend eine 200 nm dicke Siliciumschicht (40) auf die Si-Lage (2) niedergeschlagen wird.

7. Verfahren nach Anspruch 6, dadurch gekennzeichnet, daß bei korngrenzenfreier Si-Lage (2) eine Aufheiztemperatur von mehr als 500°C bei einer Aufheizdauer von 4 bis 5 Stunden angewendet wird.

8. Verfahren nach den Ansprüchen 1 oder 2 bis 6, dadurch gekennzeichnet, daß nicht-monokristallines Silicium als Si-Lage (2) verwendet wird.

9. Verfahren nach den Ansprüchen 1 bis 6 und 7, 8, dadurch gekennzeichnet, daß zunächst eine Metallsubstratoberfläche (1), insbesondere Stahl, mit einer einige 10 μm dicken, amorphen, N-dotierten Si-Lage (2) überzogen wird und anschließend hierauf die Auftragung von Aluminium und Silicium (40, 41 bzw. 42) erfolgt.

10. Verfahren nach Anspruch 8 und 9, dadurch gekennzeichnet, daß beim Niederschlagen der Si-Lage (2) erst eine N+-dotierte Schicht, die in eine N-dotierte Schicht übergeht, auf das Stahlsubstrat (1) aufgebracht wird, um dann hierauf die Si-Pyramiden auszubilden.

11. Verfahren nach den Ansprüchen 1 bis 7, dadurch gekennzeichnet, daß ein N-dotierter, monokristalliner Wafer als Si-Lage (2) entweder mit einer siliciumreichen Aluminium-Legierung (42) oder mit einer Doppelschicht, bestehend aus einer Siliciumschicht (40) und einer Aluminiumschicht (41), überzogen wird, um anschließend das Ganze in einer Argonatmosphäre zu tempern.

12. Verfahren nach Anspruch 11, dadurch gekennzeichnet, daß der als Si-Lage (2) verwendete monokristalline Wafer mittels an sich bekannter Methoden zur Ausbildung ohmscher Kontakte mit N⁻-dotiertem Si behandelt wird.

13. Verfahren nach den Ansprüchen 1 oder 4 bis 12, dadurch gekennzeichnet, daß die Ausbildung der kammförmigen Gegenelektrode (50) aus dem freigesetzten Al-Dünnfilm (5) mit Hilfe von photolithographischen oder drucktechnischen Verfahren erfolgt.

14. Verfahren nach den Ansprüchen 1 oder 4 bis 12, dadurch gekennzeichnet, daß auf den freigesetzten Al-Dünnfilm (5) eine Wachsschicht (10), insbesondere Vakuumkitt, in Form einer Kammelektrode aufgetragen wird, daß die dabei freibleibenden Metalloberflächenbereiche mittels einer Lösung, bestehend aus $H_3PO_4$, $HNO_3$, HCl und $H_2O$ im Volumen-Verhältnis 20 : 10 : 10 : 60, abgeätzt werden und schließlich die verbliebenen Teile der Wachsschicht (10) mittels $CHCl_3$ abgelöst werden.

## Claims

1. Method of making silicon photovoltaic cells, particularly solar cells, in which an Si layer (2) covered on one surface with a metal coating (1) serving as an electrode is coated on the opposite surface with a tight network of Si pyramids for providing an antireflective coating, characterized in that after the application of aluminium and silicon (40, 41, or 42) onto the surface of the N-doped Si layer (2) to be provided with the antireflective coating, there follows a heating process to below the eutectic temperature of aluminium-silicon in a netural atmosphere until Si pyramids (7) are formed which are coated with a thin Al film (5) which is subsequently partially removed to form a comb-shaped electrode (50).

2. Method as claimed in claim 1, characterised in that aluminium and silicon (40, 41 or 42) are applied on the Si layer (2) by means of cathode sputtering using a target consisting of an aluminium alloy with a high silicon content.

3. Method as claimed in claim 1, characterized in that aluminium and silicon (40, 41 or 42) is applied on the Si layer (2) by means of vacuum vapour deposition.

4. Method as claimed in claims 2 or 3, characterized in that an alloy is used as starting material consisting of 1 to 5 percent by weight of silicon in aluminium, in view of maximum silicon solubility at the respective heating temperature.

5. Method as claimed in claims 3 and 4, characterized in that when separate crucibles are used for aluminium and silicon, with their heating taking place simultaneously, correspondingly different vapour deposition rates are used for aluminium and silicon.

6. Method as claimed in claims 1, 3 and 5, characterized in that first a 400 nm thick aluminium layer (41), and then a 200 nm thick silicon layer (40) are deposited on the Si layer (2).

7. Method as claimed in claim 6, characterized in that with an Si layer (2) free of grain boundaries a heating temperature of more than 500°C with a heating time of 4 to 5 hours is used.

8. Method as claimed in claims 1 or 2 to 6, characterized in that non-monocrystalline silicon is used as Si layer (2).

9. Method as claimed in claims 1 to 6 and 7, 8, characterized in that first a metal substrate surface (1), particularly steel, is coated with an amorphous, N-doped Si layer (2) of about 10 μm thickness, and that subsequently aluminium and silicon (40, 41 or 42) are deposited thereon.

10. Method as claimed in claims 8 and 9, characterized in that during the deposition of the Si layer (2) an N+-doped layer which changes into an N doped layer is first applied onto the steel substrate (1) so that the Si pyramids are produced thereon.

11. Method as claimed in claims 1 to 7, characterized in that an N-doped, monocrystalline wafer as Si layer (2) is coated either with an aluminium alloy (42) with high silicon content, or with a double layer consisting of a silicon layer (40) and an aluminium layer (41), and that subsequently this laminate is tempered in an argon atmosphere.

12. Method as claimed in claim 11, characterized in that the monocrystalline wafer used as Si layer is processed with methods known per se for forming ohmic contacts with N⁻-doped Si.

13. Method as claimed in claim 1 or 4 to 12, characterized in that the forming of the comb-shaped counter electrode (50) out of the precipitated thin Al film (5) is effected by means of photolithographic or printing processes.

14. Method as claimed in claims 1 or 4 to 12, characterized in that onto the precipitated thin Al film (5) a wax layer (10), pratICULARLY vacuum cement, is applied in the form of a comb-shaped electrode, that the uncoated metal surface areas are etched off by means of a solution consisting of $H_3PO_4$, $HNO_3$, HCl and $H_2O$ in the volume ratio 20 : 10 : 10 : 60, and that finally the remaining parts of the wax layer (10) are removed by means of $CHCl_3$.

## Revendications

1. Procédé de fabrication d'éléments photovoltaïques à base de silicium, en particulier des cellules solaires, utilisant une couche de silicium (2), couverte d'une couche métallique (1) servant d'électrode, avec, sur la surface opposée, un réseau dense de pyramides de silicium déposé pour constituer un dépôt antiréflexion, caractérisé en ce qu'après le dépôt d'aluminium et de silicium (40, 41 et 42 respectivement) sur la surface de la couche de silicium à dopage N (2) devant constituer le dépôt anti-réflexion (4), on chauffe jusqu'à une température inférieure à la température eutectique d'aluminium-silicium en atmosphère neutre jusqu'à formation de pyramides de silicium (7) sur lesquelles est déposée une pellicule mince d'aluminium (5) qui est ensuite soumise à un procédé de décapage pour obtenir une électrode en forme de peigne (50).

2. Procédé selon la revendication 1, caractérisé en ce que l'aluminium et le silicium (40, 41 et 42 respectivement) sont déposés sur la couche de silicium (2) par pulvérisation cathodique sur une cible composée d'un alliage d'aluminium qui contient un pourcentage élevé de silicium. ·

3. Procédé selon la revendication 1, caractérisé en ce que l'aluminium et le silicium (40, 41 et 42 respectivement) sont déposés sur la couche de silicium (2) par évaporation sous vide.

4. Procédé selon l'une quelconque des revendications 2 ou 3, caractérisé en ce que l'on choisit comme matériau de base un alliage d'aluminium et de silicium contenant de 1 à 5% en poids de silicium en tenant compte de la solubilité maximale du silicium à la température de chauffage respectif.

5. Procédé selon les revendications 3 et 4, caractérisé en ce qu'en prenant des creusets séparés pour l'aluminium et le silicium et en les chauffant simultanément, il en résulte des taux d'évaporation différents pour l'aluminium et le silicium.

6. Procédé selon les revendications 1, 3 et 5, caractérisé en ce que l'on dépose d'abord une couche d'aluminium (41) d'une épaisseur de 400 nm et ensuite une couche de silicium (40) d'une épaisseur de 200 nm sur la couche de silicium.

7. Procédé selon la revendication 6, caractérisé en ce que l'on utilise, pour la couche de silicium (2) dépourvue de frontières de grain, une température de chauffage de plus de 500° C pour une durée de chauffage de 4 à 5 heures.

8. Procédé selon la revendication 1, ou l'une des revendications 2 à 6, caractérisé en ce que l'on utilise comme couche de silicium (2) du silicium non-monocristallin.

9. Procédé selon les revendications 1 à 6, et 7 ou 8, caractérisé en ce que l'on couvre d'abord une surface de substrat métallique (1), en particulier de l'acier, avec une couche de silicium (2) amorphe, à dopage N, d'une épaisseur de quelques dizaines de μm, sur laquelle on dépose ensuite de l'aluminium et du silicium (40, 41 et 42, respectivement).

10. Procédé selon les revendications 8 et 9, caractérisé en ce que lors du dépôt de la couche de silicium (2), on applique d'abord une couche à dopage N⁺ qui se transforme en couche à dopage N sur le substrat d'acier (1) afin d'y former ensuite les pyramides de silicium.

11. Procédé selon les revendications 1 à 7, caractérisé en ce que l'on dépose sur une tranche monocristalline à dopage N, servant de couche de silicium (2) un alliage d'aluminium (42), riche en silicium, ou bien une couche double comportant une couche de silicium (40) et une couche d'aluminium (41) l'ensemble étant ensuite refroidi en atmosphère d'argon.

12. Procédé selon la revendication 11, caractérisé en ce que la tranche monocristalline servant de couche de silicium (2) est traitée au moyen de procédés connus pour former des contacts ohmiques avec du silicium à dopage N⁻.

13. Procédé selon la revendication 1, ou l'une des revendications 4 à 12, caractérisé en ce que l'on utilise, pour former la contre-électrode (50) en forme de peigne obtenue à partir de la pellicule mince d'aluminium (5) un procédé photo-lithographique ou un procédé d'impression.

14. Procédé selon la revendication 1, ou l'une des revendications 4 à 12, caractérisé en ce que l'on dépose sur la pellicule mince d'aluminium (5) une couche de cire (10) en particulier du mastic de vide, sous forme d'une électrode en forme de peigne, en ce que l'on décape les régions de surface métallique non couvertes de cire à l'aide d'une solution composée de $H_3PO_4$, $HNO_3$, HCl, et $H_2O$ dans les proportions de volume de 20 : 10 : 10 : 60, et en ce que l'on enlève ensuite les parties restantes de la couche de cire (10) à l'aide de $CHCl_3$.

FIG. 1A

FIG. 1B

FIG. 1C

FIG. 1D

FIG. 1E

FIG. 1F

FIG. 1G

FIG. 2